# EUROPEAN PATENT APPLICATION

(11) **EP 4 745 443 A1**
(43) Date of publication of application: **20.05.2026**
(21) Application number: 25215230.1
(22) Date of filing: 12.11.2025
(51) Int. Cl.: F16K 31/00

(54) **PIEZOELECTRIC VALVE**

(30) Priority: 15.11.2024 JP 2024199843
(71) Applicant: SMC Corporation, Tokyo 104-0031 (JP)
(72) Inventor: OHTA, Yoshiki, Tokyo, 103-6128 (JP); SAKAMOTO, Hideya, Tokyo, 103-6128 (JP); ABE, Ryunosuke, Tokyo, 103-6128 (JP); WATANABE, Takashi, Ibaraki, 300-2493 (JP)
(74) Representative: Keil & Schaafhausen Patentanwälte PartGmbB

(57) **Abstract**

A piezoelectric valve (1) includes a housing (2) provided with an inflow hole (P1) and an outflow hole (P2) for air, and a valve element (3) disposed in the housing and configured to open and close the inflow hole. The valve element is configured by a piezoelectric unit (11) including a plate-shaped piezoelectric element (12) and a diaphragm (13) on which the piezoelectric element is stacked. The inflow hole does not overlap the piezoelectric element but overlaps only the diaphragm when viewed from a stacking direction of the piezoelectric element in the piezoelectric unit.

## Description

### TECHNICAL FIELD

The present disclosure relates to a piezoelectric valve.

### BACKGROUND

A piezoelectric element has a characteristic of being deformed by an inverse piezoelectric effect, and is used as a piezoelectric actuator that converts an electric signal into physical deformation (see, for example, Japanese Unexamined Patent Publication No. H04-6885). Examples of a use destination of the piezoelectric actuator include a piezoelectric valve. The piezoelectric valve can be applied to, for example, a pneumatic regulator. The pneumatic regulator is attached to a pipe of compressed air used in a factory or the like, and has a function of keeping a pressure in the pipe constant.

### SUMMARY

In a piezoelectric valve, a piezoelectric element using distortion deformation is generally used. The piezoelectric valve includes, for example, a piezoelectric element and a diaphragm electrically connected to the piezoelectric element. The piezoelectric valve includes a housing having an inflow hole into which air from a primary side flows and an outflow hole from which air flows out to a secondary side. The piezoelectric element is disposed inside the housing so as to close the inflow hole, as a valve element that opens and closes the inflow hole by distortion deformation.

In the piezoelectric valve having such a configuration, vibration is applied to the piezoelectric element when the inflow hole is opened and closed. Therefore, when the opening and closing of the inflow hole are repeated, vibration is repeatedly applied to the piezoelectric element, and cracks may occur in the piezoelectric element. Examples of measures against cracks include improvement in strength by securing a thickness of the piezoelectric element, reduction in an amount of distortion deformation of the piezoelectric element, and the like, but there is a possibility of causing a decrease in the degree of freedom in design.

The present disclosure has been made to solve the above problems, and an object of the present disclosure is to provide a piezoelectric valve capable of suppressing occurrence of cracks in a piezoelectric element with a simple configuration.

The gist of the present disclosure is as follows.
[1] A piezoelectric valve including: a housing provided with an inflow hole and an outflow hole for air; and a valve element disposed in the housing and configured to open and close the inflow hole, in which the valve element is configured by a piezoelectric unit including a plate-shaped piezoelectric element and a diaphragm on which the piezoelectric element is stacked, and the inflow hole does not overlap the piezoelectric element but overlaps only the diaphragm when viewed from a stacking direction of the piezoelectric element in the piezoelectric unit.
   In this piezoelectric valve, when viewed from the stacking direction of the piezoelectric element in the piezoelectric unit, the inflow hole overlaps only the diaphragm, and the piezoelectric element is in a state of being separated from the inflow hole. When the valve element opens and closes the inflow hole, the diaphragm hits the inflow hole to repeatedly apply vibration to the piezoelectric element. However, since the piezoelectric element is separated from the inflow hole, the vibration applied to the piezoelectric element is alleviated. Therefore, in this piezoelectric valve, the occurrence of cracks in the piezoelectric element can be suppressed with a simple configuration without taking measures such as improving a strength by securing a thickness of the piezoelectric element and reducing a distortion deformation amount of the piezoelectric element.
[2] The piezoelectric valve according [1], in which an end portion of the diaphragm on the inflow hole side is a free end, and an end portion of the diaphragm on a side opposite to the inflow hole is a fixed end. By setting the end portion of the diaphragm opposite to the inflow hole as the fixed end, it is possible to set the free end of the diaphragm as a main deformation portion when the piezoelectric element is distorted and deformed. Therefore, the function of the piezoelectric unit as the valve element can be sufficiently exhibited.
[3] The piezoelectric valve according to [2], in which the inflow hole is opened and closed by the free end of the diaphragm. In this case, the function of the piezoelectric unit as the valve element can be sufficiently exhibited, and the occurrence of cracks in the piezoelectric element can be suitably suppressed.
[4] The piezoelectric valve according to any one of [1] to [3], in which an entirety of the inflow hole overlaps the diaphragm when viewed from the stacking direction of the piezoelectric element in the piezoelectric unit. In this case, the function of the piezoelectric unit as the valve element can be sufficiently exhibited, and the occurrence of cracks in the piezoelectric element can be suitably suppressed.
[5] The piezoelectric valve according to any one of [1] to [4], in which a biasing portion that biases the diaphragm toward the inflow hole is disposed at a position facing the inflow hole with the diaphragm interposed therebetween. In this case, the function of the piezoelectric unit as the valve element can be sufficiently exhibited by the biasing portion. In addition, since the portion biased by the biasing portion is the diaphragm, the occurrence of cracks in the piezoelectric element can be suitably suppressed.
[6] The piezoelectric valve according to any one of [1] to [5], in which an elastic member is disposed between the diaphragm and the inflow hole. In this case, the elastic member can function as a sealing member, and airtightness when the inflow hole is closed can be enhanced. In addition, the elastic member can function as a vibration absorbing member that alleviates vibration when the diaphragm hits the inflow hole. This makes it possible to more reliably suppress the occurrence of cracks in the piezoelectric element.
[7] The piezoelectric valve according to [6], in which the elastic member is fixed to the diaphragm. In this case, since the elastic member can be disposed together with the arrangement of the piezoelectric unit, assembling of the piezoelectric valve can be facilitated.

### BRIEF DESCRIPTION OF THE DRAWINGS

FIG. 1 is a perspective view of a piezoelectric valve according to one embodiment of the present disclosure;
FIG. 2 is an exploded perspective view of the piezoelectric valve illustrated in FIG. 1;
FIG. 3 is a plan view of the piezoelectric valve illustrated in FIG. 1;
FIG. 4A is a cross-sectional view of the piezoelectric valve in a state where an inflow hole is closed;
FIG. 4B is a cross-sectional view of the piezoelectric valve in a state where the inflow hole is opened;
FIG. 5 is a perspective view of a piezoelectric unit;
FIG. 6 is a side view of the piezoelectric unit illustrated in FIG. 5; and
FIG. 7 is a view illustrating a circuit configuration of the piezoelectric unit.

### DETAILED DESCRIPTION

Hereinafter, a preferred embodiment of a piezoelectric valve according to one aspect of the present disclosure will be described in detail with reference to the drawings.

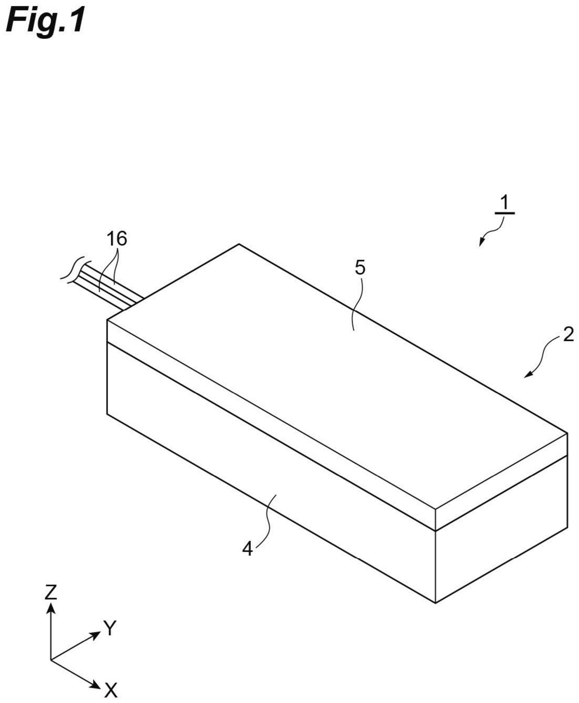

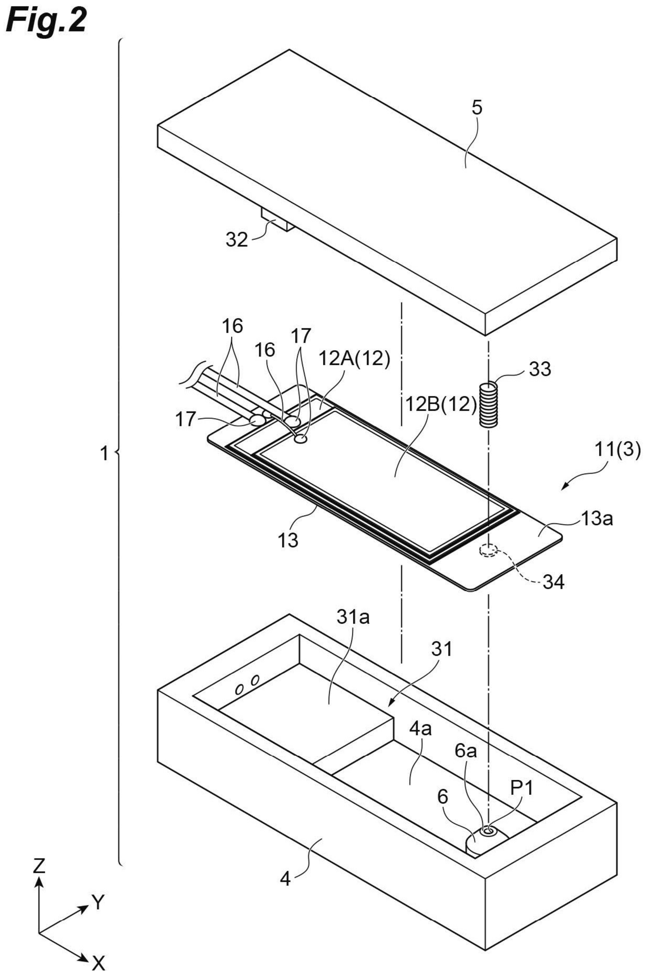

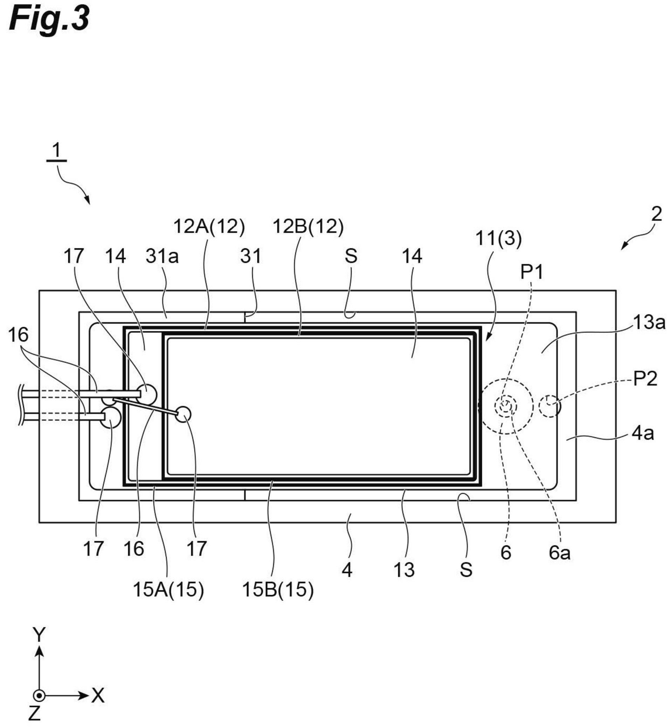

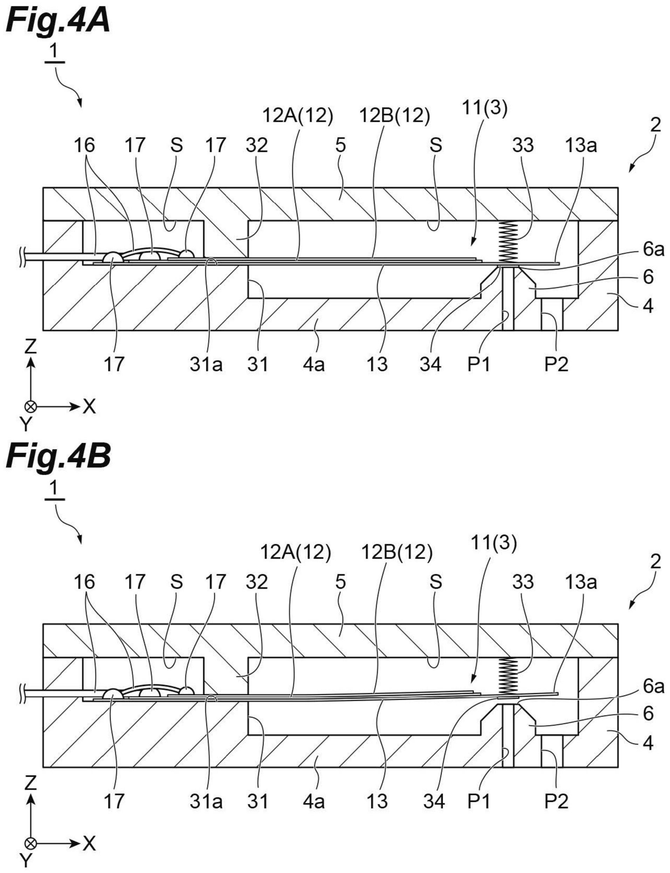

FIG. 1 is a perspective view of a piezoelectric valve according to one embodiment of the present disclosure. FIG. 2 is an exploded perspective view of the piezoelectric valve. FIG. 3 is a plan view of the piezoelectric valve, and FIGS. 4A and 4B are cross-sectional views of the piezoelectric valve. For convenience of description, FIG. 3 illustrates a plan view of a state in which a lid portion of a housing is removed.

A piezoelectric valve 1 illustrated in FIGS. 1 to 4A, 4B is a device applied to, for example, a pneumatic regulator. The pneumatic regulator is attached to a pipe of compressed air used in a factory or the like, and has a function of keeping a pressure in the pipe constant. As illustrated in FIGS. 1 to 4A, 4B, the piezoelectric valve 1 includes a housing 2 and a valve element 3.

The housing 2 is made of, for example, resin, and includes a bottomed main body portion 4 whose one surface side is opened, and a lid portion 5 fixed to one surface of the main body portion 4 so as to close the opening of the main body portion 4. The housing 2 has a substantially rectangular box shape having an airtight internal space S by fixing the lid portion 5 to the main body portion 4 via a seal member (not illustrated). In the following description, it is assumed that a longitudinal direction of the housing 2 (a direction along a long side in plan view) is an X direction, a lateral direction of the housing 2 (a direction along a short side in plan view) is a Y direction, and a thickness direction of the housing 2 is a Z direction.

The housing 2 is provided with an inflow hole P1 and an outflow hole P2 for air (see FIG. 3). The inflow hole P1 and the outflow hole P2 both have a circular cross section and communicate with the internal space S of the housing 2. The inflow hole P1 is a portion that allows air on a primary side to flow into the housing 2. The inflow hole P1 is provided at one end side in the X direction and at a center in the Y direction in a bottom portion 4a of the main body portion 4, for example. At the position of the inflow hole P1, a nozzle 6 protruding toward the lid portion 5 side in the internal space S is provided.

The outflow hole P2 is a portion that allows air in the housing 2 to flow out to a secondary side. The outflow hole P2 is provided closer to the one end side in the X direction than the inflow hole P1 and at the center in the Y direction, for example, in the bottom portion 4a of the main body portion 4. An inner diameter of the inflow hole P1 and an inner diameter of the outflow hole P2 are not particularly limited, but in the present embodiment, the inner diameter of the outflow hole P2 is larger than the inner diameter of the inflow hole P1.

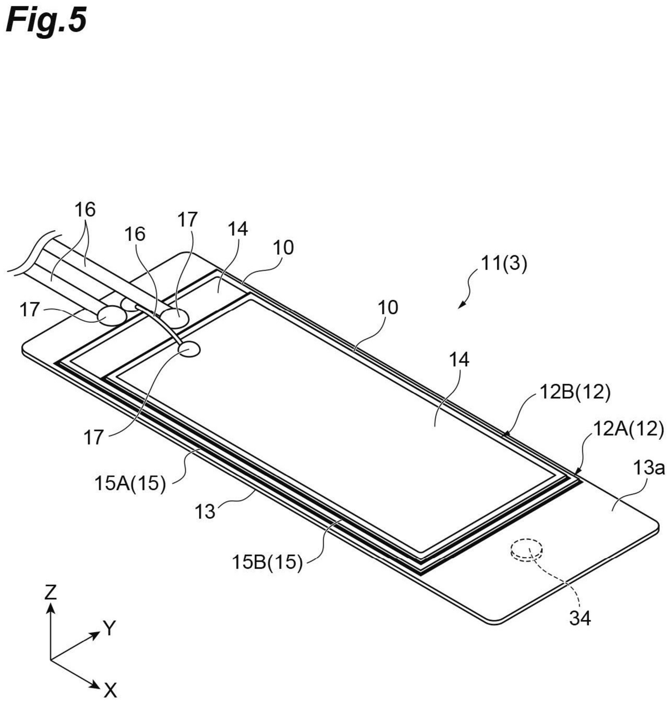

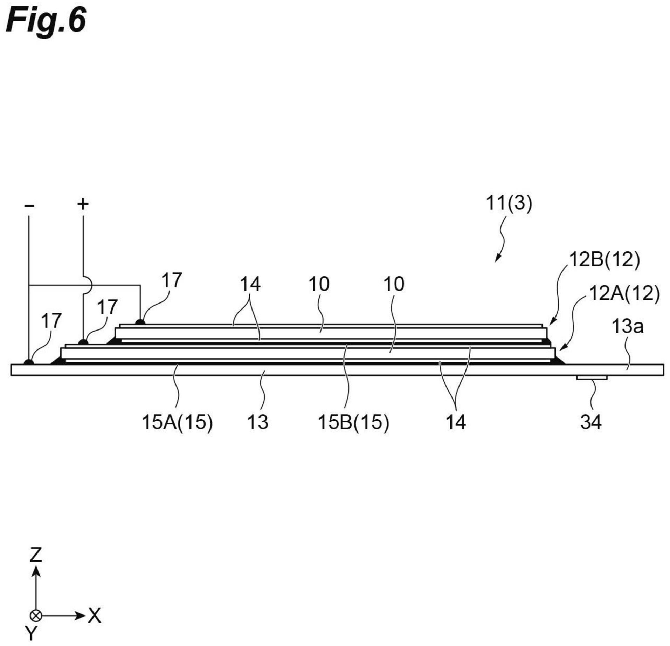

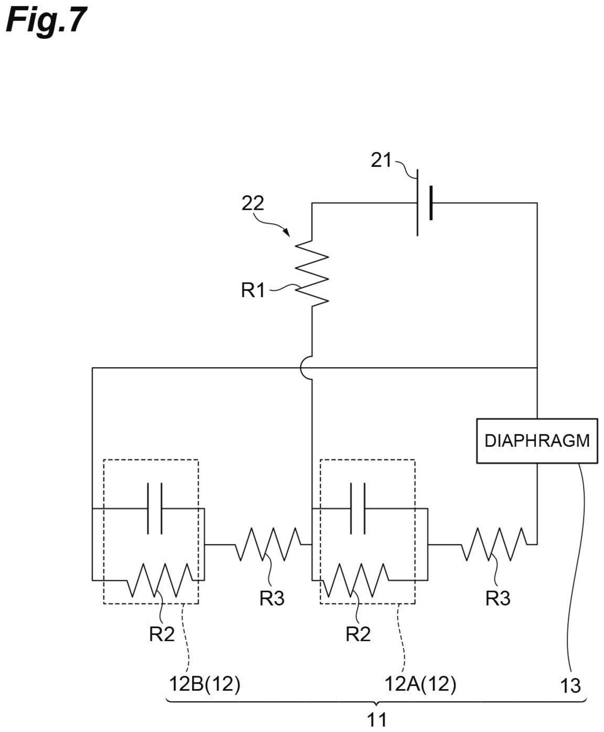

The valve element 3 is disposed in the housing 2 and opens and closes the inflow hole P1. As illustrated in FIGS. 5 and 6, the valve element 3 is configured by a piezoelectric unit 11 including plate-shaped piezoelectric elements 12 and a diaphragm 13 on which the piezoelectric elements 12 are stacked. The piezoelectric unit 11 is DC-driven by a voltage supplied from a power supply unit 21 (see FIG. 7) to be described later. By the DC driving, the piezoelectric elements 12 and the diaphragm 13 are distorted and deformed toward the lid portion 5. As a result, a closed state (see FIG. 4A) in which the diaphragm 13 abuts on a distal end surface 6a of the nozzle 6 of the inflow hole P1 and an open state (see FIG. 4B) in which the diaphragm 13 is separated from the distal end surface 6a of the nozzle 6 of the inflow hole P1 are switched, and the inflow hole P1 is opened and closed.

The diaphragm 13 has, for example, a rectangular shape in plan view. The diaphragm 13 is formed of a conductive material such as metal. The constituent material of the diaphragm 13 may be carbon fiber reinforced plastic, 42 alloy, or the like. A thickness of the diaphragm 13 may be about the same as a thickness of the piezoelectric element 12, or may be slightly larger than the thickness of the piezoelectric element 12.

A notch portion may be provided at any corner of the diaphragm 13. The notch portion serves as a mark for visually recognizing front and back surfaces of the diaphragm 13, and contributes to improvement in mounting workability when the piezoelectric unit 11 is mounted to the housing 2. A shape of the notch portion (a shape cut out by the notch portion) can be various shapes such as a triangular shape, a rectangular shape, and an arc shape.

In the present embodiment, as illustrated in FIGS. 5 and 6, the piezoelectric unit 11 includes a plurality of plate-shaped piezoelectric elements 12 (a piezoelectric element 12A and a piezoelectric element 12B). Each of the piezoelectric elements 12 includes an element body 10 and a pair of electrodes 14. The element body 10 does not have an internal electrode and is configured by a single piezoelectric layer. The piezoelectric layer is formed of a piezoelectric material such as a piezoelectric ceramic. Examples of the piezoelectric ceramic material include PZT[Pb(Zr, Ti)O₃], PT(PbTiO₃), PLZT[(Pb, La)(Zr, Ti)O₃], barium titanate (BaTiO₃), and the like.

The electrodes 14 are provided on both surfaces of the piezoelectric element 12. The electrode 14 is configured by, for example, a metal-plated film formed by sputtering, vapor deposition, or the like. That is, the electrode 14 is formed of a sputtered film or a deposited film. The electrode 14 may be configured by a multilayer metal-plated film. Examples of the constituent material of the electrode 14 include stable metals such as chromium (Cr)/copper-nickel alloy (Ni-Cu)/gold (Au)/platinum (Pt). A planar shape of the electrodes 14 on both surfaces of the piezoelectric element 12 is, for example, a rectangular shape slightly smaller than a planar shape of the element body 10. The electrode 14 is disposed in a region inside a contour of the piezoelectric element 12 in plan view of the piezoelectric element 12, and a frame-shaped electrode non-forming region is formed at an edge portion of the piezoelectric element 12.

The piezoelectric unit 11 is configured by, for example, stacking a plurality of piezoelectric elements 12 having different dimensions in the longitudinal direction on the diaphragm 13 in descending order of the dimensions. In the example of FIGS. 5 and 6, the piezoelectric element 12A and the piezoelectric element 12B are stacked in this order in parallel with each other on one surface of the diaphragm 13. The electrode 14 on one surface side of the piezoelectric element 12A is in contact with the one surface of the diaphragm 13, and the electrode 14 on the other surface side of the piezoelectric element 12A is in contact with the electrode 14 on one surface side of the piezoelectric element 12B. As a result, the diaphragm 13 and the piezoelectric element 12A are electrically connected to each other, and the piezoelectric element 12A and the piezoelectric element 12B are electrically connected to each other. In the present embodiment, a thickness of the piezoelectric element 12A and a thickness of the piezoelectric element 12B are equal to each other. One of the thickness of the piezoelectric element 12A and the thickness of the piezoelectric element 12B may be larger than the other.

The piezoelectric element 12A overlapping the diaphragm 13 is an element that mainly contributes to a displacement amount of the piezoelectric unit 11. The dimension of the piezoelectric element 12A in the X direction is smaller than the dimension of the diaphragm 13 in the X direction. As a result, the position of the piezoelectric element 12A with respect to the diaphragm 13 can be arbitrarily adjusted in the X direction. In the present embodiment, the piezoelectric element 12A is located closer to the other end in the X direction on the one surface of the diaphragm 13. A protruding length of the diaphragm 13 from one end of the piezoelectric element 12A in the X direction is larger than a protruding length of the diaphragm 13 from the other end of the piezoelectric element 12A in the X direction. A dimension of the piezoelectric element 12A in the Y direction is slightly smaller than a dimension of the diaphragm 13 in the Y direction. Due to this dimensional difference, a margin for forming an adhesive portion 15A to be described later is provided on the one surface of the diaphragm 13.

The piezoelectric element 12B overlapping the piezoelectric element 12A is an element that mainly contributes power (torque) of the piezoelectric unit 11. A dimension of the piezoelectric element 12B in the X direction is smaller than the dimension of the piezoelectric element 12A in the X direction. The piezoelectric element 12B is unevenly distributed on the one end side of the piezoelectric element 12A in the X direction to such an extent that the electrode non-forming region at the one end of the piezoelectric element 12A in the X direction is slightly exposed. A dimension of the piezoelectric element 12B in the Y direction is slightly smaller than the dimension of the piezoelectric element 12A in the Y direction. Due to this dimensional difference, a margin for forming an adhesive portion 15B to be described later is provided in the electrode non-forming region of the piezoelectric element 12A.

An adhesive portion 15 is provided for joining the diaphragm 13 and the piezoelectric element 12A and joining the piezoelectric element 12A and the piezoelectric element 12B. From the viewpoint of preventing occurrence of a short circuit, the adhesive portion 15 is made of, for example, an adhesive material not containing a conductive component such as conductive particles. Examples of the adhesive material constituting the adhesive portion 15 include a thermosetting epoxy resin. The adhesive portion 15 is disposed in a region inside the contour of the piezoelectric element 12 when viewed from the Z direction. Further, the adhesive portion 15 may be disposed so as to protrude outward from the contour of the piezoelectric element 12 when viewed from the Z direction.

In the present embodiment, as illustrated in FIGS. 5 and 6, the adhesive portion 15A used for joining the diaphragm 13 and the piezoelectric element 12A is disposed over the entire one surface of the piezoelectric element 12A so as to connect the one surface of the diaphragm 13 and the electrode 14 on the one surface of the piezoelectric element 12A. A part of the adhesive portion 15A protrudes slightly outward from a contour of the piezoelectric element 12A and is disposed so as to wrap around the side surfaces of the piezoelectric element 12A. In the example of FIGS. 5 and 6, the adhesive portion 15A protrudes outward from all end edges of the piezoelectric element 12A. The adhesive portion 15A may protrude outward from some of end edges of the piezoelectric element 12A. In this case, for example, the adhesive portion 15A may protrude outward from only both end edges of the piezoelectric element 12A in the X direction, or may protrude outward from only both end edges of the piezoelectric element 12A in the Y direction.

The adhesive portion 15B used for joining the piezoelectric element 12B and the piezoelectric element 12A is disposed over the entire one surface of the piezoelectric element 12B so as to connect the electrode 14 on the other surface of the piezoelectric element 12A and the electrode 14 on the one surface of the piezoelectric element 12B. A part of the adhesive portion 15B protrudes slightly outward from a contour of the piezoelectric element 12B and is disposed so as to wrap around the side surfaces of the piezoelectric element 12B. In the example of FIGS. 5 and 6, the adhesive portion 15B protrudes outward from all end edges of the piezoelectric element 12B. The adhesive portion 15B may protrude outward from some of end edges of the piezoelectric element 12B. In this case, for example, the adhesive portion 15B may protrude outward from only both end edges of the piezoelectric element 12B in the X direction, or may protrude outward from only both end edges of the piezoelectric element 12B in the Y direction.

As described above, the adhesive portion 15 is made of an adhesive material not containing a conductive component. A driving voltage of the piezoelectric unit 11 includes, for example, a high voltage of about several hundred V. Therefore, even in a state in which the adhesive portions 15A and 15B made of an adhesive material not containing a conductive component are interposed, the electrical connection between the diaphragm 13 and the piezoelectric element 12A and the electrical connection between the piezoelectric element 12A and the piezoelectric element 12B are respectively maintained.

As illustrated in FIG. 5, the piezoelectric unit 11 includes wiring portions 16 used for driving the piezoelectric element 12. The wiring portions 16 are electrically connected to the one surface of the diaphragm 13, the electrode 14 on the other surface side of the piezoelectric element 12A, and the electrode 14 on the other surface side of the piezoelectric element 12B respectively by joining portions 17. Similarly to the adhesive portion 15, the joining portion 17 is made of an adhesive material not containing a conductive component. The joining portion 17 may be configured by, for example, solder joining. In this case, examples of a solder material used for the joining portion 17 include SnAg-Cu.

FIG. 7 is a view illustrating a circuit configuration of the piezoelectric unit. As illustrated in FIG. 7, the power supply unit 21 for driving is electrically connected to the piezoelectric unit 11. The piezoelectric element 12A and the piezoelectric element 12B are electrically connected in parallel. The diaphragm 13, the piezoelectric element 12A, and the piezoelectric element 12B are electrically connected in series. A resistor 22 is electrically connected in series between the piezoelectric element 12A and the piezoelectric element 12B electrically in parallel and the power supply unit 21.

The resistor 22 functions as a protective resistor that prevents an excessive current from flowing through the piezoelectric element 12A and the piezoelectric element 12B. In the present embodiment, an electric resistance value R1 of the resistor 22 is less than an insulation resistance value R2 of each of the piezoelectric element 12A and the piezoelectric element 12B. An electric resistance value R1 of the resistor 22 is larger than a contact resistance value R3 between the diaphragm 13 and the electrode 14 of the piezoelectric element 12 (here, the piezoelectric element 12A). In addition, the electric resistance value R1 of the resistor 22 is larger than the contact resistance value R3 between the electrodes 14 of the plurality of piezoelectric elements 12 (here, the piezoelectric element 12A and the piezoelectric element 12B).

The insulation resistance value R2 of each of the piezoelectric element 12A and the piezoelectric element 12B corresponds to an electric resistance value of the element body 10 which is an insulator. The contact resistance value R3 between the diaphragm 13 and the electrode 14 of the piezoelectric element 12A corresponds to an electric resistance value between the one surface of the diaphragm 13 and the electrode 14 on the one surface of the piezoelectric element 12A via the adhesive portion 15A. The contact resistance value R3 between the electrodes 14 of the piezoelectric element 12A and the piezoelectric element 12B corresponds to an electric resistance value between the electrode 14 on the other surface of the piezoelectric element 12A and the electrode 14 on the one surface of the piezoelectric element 12B via the adhesive portion 15B. As an example, when the insulation resistance value R2 of each of the piezoelectric element 12A and the piezoelectric element 12B is 1 × 10⁹ Ω, the contact resistance value R3 between the diaphragm 13 and the electrode 14 of the piezoelectric element 12A and the contact resistance value R3 between the electrodes 14 of the piezoelectric element 12A and the piezoelectric element 12B are 1 × 10² Ω, the electric resistance value R1 of the resistor 22 is set to 1 × 10⁵ Ω.

In fixing the above-described piezoelectric unit 11 in the housing 2, as illustrated in FIGS. 4A and 4B, the main body portion 4 of the housing 2 is provided with a stepped portion 31. The stepped portion 31 is provided on the other end side in the X direction in the bottom portion 4a of the main body portion 4. A top surface 31a of the stepped portion 31 is a flat surface and has a rectangular shape in plan view. A height of the stepped portion 31 from the bottom portion 4a is, for example, about the same as a protruding amount of the nozzle 6 from the bottom portion 4a.

The piezoelectric unit 11 is disposed on the stepped portion 31 in a state where the joining portions 17 are located on the stepped portion 31 and a protruding portion 13a of the diaphragm 13 from one end of the piezoelectric element 12A in the X direction faces the nozzle 6 side. The other end side of the diaphragm 13 in the X direction is fixed to the top surface 31a of the stepped portion 31 by a joining member such as an adhesive or a double-sided tape. As a result, the diaphragm 13 is cantilevered on the stepped portion 31. An end portion of the diaphragm 13 on the inflow hole P1 side is a free end, and an end portion of the diaphragm 13 on the side opposite to the inflow hole P1 is a fixed end. The wiring portions 16 are located on the fixed end side of the diaphragm 13 as the joining portions 17 are located on the stepped portion 31.

In the present embodiment, as illustrated in FIGS. 4A and 4B, the lid portion 5 of the housing 2 is provided with a protrusion 32 protruding toward the stepped portion 31 as a configuration for reinforcing cantilever support of the diaphragm 13. The protrusion 32 is provided with a constant width so as to extend in the Y direction, and a distal end of the protrusion 32 is a flat surface. The protrusion 32 holds the fixed end side of the diaphragm 13 by sandwiching the diaphragm 13 and the piezoelectric elements 12 (the piezoelectric element 12A and the piezoelectric element 12B described above) between the protrusion 32 and the stepped portion 31.

The inflow hole P1 is opened and closed by the free end of the diaphragm 13. In the present embodiment, in the cantilevered diaphragm 13, the protruding portion 13a of the diaphragm 13 from the one end of the piezoelectric element 12A in the X direction abuts on the distal end surface 6a of the nozzle 6 defining the inflow hole P1. As illustrated in FIG. 3, the inflow hole P1 does not overlap the piezoelectric elements 12 in the piezoelectric unit 11, but overlaps only the diaphragm 13 when viewed from the stacking direction (Z direction) of the piezoelectric elements 12. In the example of FIG. 3, when viewed from the stacking direction (Z direction) of the piezoelectric elements 12 in the piezoelectric unit 11, the distal end surface 6a of the nozzle 6 does not overlap either the piezoelectric element 12A or the piezoelectric element 12B, and overlaps only the diaphragm 13.

Similarly to the distal end surface 6a, a portion of the nozzle 6 not in contact with the diaphragm 13, that is, a portion excluding the distal end surface 6a of the nozzle 6 may not overlap either the piezoelectric element 12A or the piezoelectric element 12B, and may overlap only the diaphragm 13 when viewed from the stacking direction (Z direction) of the piezoelectric elements 12 in the piezoelectric unit 11. A portion of the nozzle 6 excluding the distal end surface 6a may partially overlap the piezoelectric element 12A or both the piezoelectric element 12A and the piezoelectric element 12B when viewed from the stacking direction (Z direction) of the piezoelectric elements 12 in the piezoelectric unit 11.

In the example of FIG. 3, when viewed from the stacking direction (Z direction) of the piezoelectric elements 12 in the piezoelectric unit 11, a part of the outflow hole P2 overlaps the diaphragm 13, but a positional relationship between the outflow hole P2 and the piezoelectric unit 11 is not particularly limited. The entire outflow hole P2 may overlap the diaphragm 13 when viewed from the stacking direction (Z direction) of the piezoelectric elements 12 in the piezoelectric unit 11. When viewed from the stacking direction (Z direction) of the piezoelectric elements 12 in the piezoelectric unit 11, the outflow hole P2 may overlap both the piezoelectric elements 12 and the diaphragm 13.

As illustrated in FIGS. 4A and 4B, a biasing portion 33 that biases the diaphragm 13 toward the inflow hole P1 is disposed at a position facing the inflow hole P1 with the diaphragm 13 interposed therebetween. In the present embodiment, the biasing portion 33 is formed of a spring member such as a coil spring. The biasing portion 33 is disposed in the internal space S between the lid portion 5 and the protruding portion 13a of the diaphragm 13 so as to face the inflow hole P1 with the diaphragm 13 interposed therebetween. The protruding portion 13a of the diaphragm 13 is pressed against the distal end surface 6a of the nozzle 6 by the biasing portion 33, whereby the closed state of the inflow hole P1 when the piezoelectric elements 12 are not distorted and deformed is maintained.

An elastic member 34 is disposed between the diaphragm 13 and the inflow hole P1. The elastic member 34 is made of, for example, an elastomer and is formed in a disk shape having a diameter larger than the inner diameter of the inflow hole P1. In the present embodiment, the elastic member 34 is fixed to the surface of the protruding portion 13a of the diaphragm 13 on the nozzle 6 side by a joining member such as an adhesive or a double-sided tape. The elastic member 34 functions as a sealing member that enhances airtightness when the inflow hole is closed. In addition, the elastic member 34 functions as a vibration absorbing member that alleviates vibration when the diaphragm 13 hits the inflow hole P1 (the distal end surface 6a of the nozzle 6).

As described above, in the piezoelectric valve 1, when viewed from the stacking direction of the piezoelectric elements 12 in the piezoelectric unit 11, the inflow hole P1 overlaps only the diaphragm 13, and the piezoelectric elements 12 are in a state of being separated from the inflow hole P1. When the valve element 3 opens and closes the inflow hole P1, the diaphragm 13 hits the inflow hole P1 to repeatedly apply vibration to the piezoelectric elements 12. However, since the piezoelectric elements 12 are separated from the inflow hole P1, the vibration applied to the piezoelectric elements 12 is alleviated. Therefore, in the piezoelectric valve 1, the occurrence of cracks in the piezoelectric elements 12 can be suppressed with a simple configuration without taking measures such as improving a strength by securing a thickness of the piezoelectric element 12 and reducing a distortion deformation amount of the piezoelectric element 12.

In the present embodiment, an end portion of the diaphragm 13 on the inflow hole P1 side is a free end, and an end portion of the diaphragm 13 on the side opposite to the inflow hole P1 is a fixed end. By setting the end portion of the diaphragm 13 on the side opposite to the inflow hole P1 as the fixed end, it is possible to set the free end of the diaphragm 13 as a main deformation portion when the piezoelectric elements 12 are distorted and deformed. Therefore, the function of the piezoelectric unit 11 as the valve element 3 can be sufficiently exhibited.

In the present embodiment, the inflow hole P1 is opened and closed by the free end of the diaphragm 13. In this case, the function of the piezoelectric unit 11 as the valve element 3 can be sufficiently exhibited, and the occurrence of cracks in the piezoelectric elements 12 can be suitably suppressed. In the present embodiment, the entire inflow hole P1 overlaps the diaphragm 13 when viewed from the stacking direction of the piezoelectric elements 12 in the piezoelectric unit 11. In this case, the function of the piezoelectric unit 11 as the valve element 3 can be sufficiently exhibited, and the occurrence of cracks in the piezoelectric elements 12 can be suitably suppressed.

In the present embodiment, the biasing portion 33 that biases the diaphragm 13 toward the inflow hole P1 is disposed at a position facing the inflow hole P1 with the diaphragm 13 interposed therebetween. The function of the piezoelectric unit as the valve element 3 can be sufficiently exhibited by the biasing portion 33. Further, since the portion biased by the biasing portion 33 is the diaphragm 13 (protruding portion 13a), the occurrence of cracks in the piezoelectric elements 12 can be suitably suppressed.

In the present embodiment, the elastic member 34 is disposed between the diaphragm 13 and the inflow hole P1. In this case, the elastic member 34 can function as a sealing member, and airtightness when the inflow hole P1 is closed can be enhanced. In addition, the elastic member 34 can function as a vibration absorbing member that alleviates vibration when the diaphragm 13 hits the inflow hole P1. This makes it possible to more reliably suppress the occurrence of cracks in the piezoelectric elements 12. In the present embodiment, the elastic member 34 is fixed to the diaphragm 13. In this case, since the elastic member 34 can be disposed together with the arrangement of the piezoelectric unit 11, the assembly of the piezoelectric valve 1 can be facilitated.

The present disclosure is not limited to the above-described embodiment. For example, in the above embodiment, the piezoelectric unit 11 is configured by a stacked body in which the piezoelectric elements 12A and 12B having different dimensions in the longitudinal direction are stacked, but the dimensions of the piezoelectric elements 12A and 12B in the longitudinal direction may be equal to each other. The number of stacked layers of the piezoelectric elements 12 on the diaphragm 13 is not limited to two, and may be a single layer or three or more layers.

Further, for example, in the above embodiment, the diaphragm 13 and the piezoelectric elements 12A and 12B disposed on the stepped portion 31 are sandwiched by the protrusion 32 in the lid portion 5, but instead of the protrusion 32, an elastic member such as a plate spring may be disposed in the internal space S between the stepped portion 31 and the lid portion 5, and the diaphragm 13 and the piezoelectric element 12 (the piezoelectric element 12A and the piezoelectric element 12B described above) may be pressed by the elastic member.

## Claims

1. A piezoelectric valve (1) comprising:
a housing (2) provided with an inflow hole (P1) and an outflow hole (P2) for air; and
a valve element (3) disposed in the housing and configured to open and close the inflow hole,
wherein the valve element is configured by a piezoelectric unit (11) including a plate-shaped piezoelectric element (12) and a diaphragm (13) on which the piezoelectric element is stacked, and
the inflow hole does not overlap the piezoelectric element but overlaps only the diaphragm when viewed from a stacking direction of the piezoelectric element in the piezoelectric unit.

2. The piezoelectric valve according to claim 1, wherein an end portion of the diaphragm on the inflow hole side is a free end, and an end portion of the diaphragm on a side opposite to the inflow hole is a fixed end.

3. The piezoelectric valve according to claim 2, wherein the inflow hole is opened and closed by the free end of the diaphragm.

4. The piezoelectric valve according to claim 1, wherein an entirety of the inflow hole overlaps the diaphragm when viewed from the stacking direction of the piezoelectric element in the piezoelectric unit.

5. The piezoelectric valve according to claim 1, wherein a biasing portion (33) that biases the diaphragm toward the inflow hole is disposed at a position facing the inflow hole with the diaphragm interposed therebetween.

6. The piezoelectric valve according to claim 1, wherein an elastic member (34) is disposed between the diaphragm and the inflow hole.

7. The piezoelectric valve according to claim 6, wherein the elastic member is fixed to the diaphragm.
